# FASCICULE DE BREVET EUROPEEN

(11) **EP 3 745 483 B1**
(45) Date de publication et mention de la délivrance du brevet: **31.07.2024**
(21) Numéro de dépôt: 20175836.4
(22) Date de dépôt: 20.05.2020
(51) Int. Cl.: H10N 70/20, H10B 63/10

(54) **MÉMOIRE À CHANGEMENT DE PHASE ET SON PROCÉDÉ DE FABRICATION**
PHASENWECHSELSPEICHER UND DESSEN HERSTELLUNGSVERFAHREN
PHASE-CHANGE MEMORY AND FABRICATION METHOD THEREOF

(30) Priorité: 28.05.2019 FR 1905665
(43) Date de publication de la demande: 02.12.2020
(73) Titulaire: STMicroelectronics (Crolles 2) SAS, 38920 Crolles (FR); STMicroelectronics (Rousset) SAS, 13790 Rousset (FR)
(72) Inventeur: BOIVIN, Philippe, 13770 Venelles (FR); BENOIT, Daniel, 38100 Grenoble (FR); BERTHELON, Remy, 38400 Saint-Martin-d'Hères (FR)
(74) Mandataire: Cabinet Beaumont

(56) Documents cités:
- FR-A1- 3 066 038
- US-A1- 2007 029 676
- US-A1- 2007 111 440

## Description

### Domaine technique

La présente description concerne de façon générale les dispositifs électroniques et plus particulièrement les mémoires à changement de phase.

### Technique antérieure

Les mémoires sont généralement sous forme de matrices, comprenant des lignes de mot ("wordline") et des lignes de bit ("bitline"). Une cellule mémoire contenant une information binaire se situe à chaque croisement d'une ligne de mot et d'une ligne de bit.

Dans une mémoire à changement de phase, chaque cellule mémoire comprend une bande de matériau à changement de phase dont la partie inférieure est en contact avec un élément résistif. Les matériaux à changement de phase sont des matériaux qui peuvent basculer d'une phase cristalline à une phase amorphe et inversement. Ce basculement est provoqué par une augmentation de la température de l'élément résistif sous-jacent dans lequel on fait passer un courant électrique. La différence de résistance électrique entre la phase amorphe du matériau et sa phase cristalline est utilisée pour définir deux états de mémoire, arbitrairement 0 et 1.

Dans l'exemple d'une mémoire à changement de phase, les cellules mémoire sont par exemple commandées par des transistors de sélection qui font passer, ou non, le courant servant à chauffer les éléments résistifs. Les cellules mémoire appartenant à une même ligne de bit sont interconnectées par un conducteur recouvrant le matériau à changement de phase et les cellules mémoire appartenant à une même ligne de mot sont interconnectées ensemble par une borne des transistors commune à tous les transistors d'une même ligne de mot.

L'information binaire d'une cellule mémoire d'une mémoire à changement de phase est par exemple accédée, ou lue, en mesurant la résistance entre la ligne de bit et la ligne de mot de la cellule mémoire.

Le document US 2007/0029676 décrit un dispositif mémoire à changement de phase et son procédé de fabrication selon le préambule des revendications indépendantes 1 et 2.

Le document US 2007/0111440 décrit un réseau de cellules mémoires à changement de phase et son procédé de fabrication.

Le document FR 3 066 038 décrit une mémoire à changement de phase. Résumé de l'invention

Un mode de réalisation pallie tout ou partie des inconvénients des mémoires à changement de phase connus.

Un mode de réalisation prévoit un procédé de fabrication d'une mémoire à changement de phase tel que défini dans la revendication indépendante 1.

Un mode de réalisation prévoit un dispositif mémoire à changement de phase tel que défini dans la revendication indépendante 2.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 comprend une vue en coupe (1a) selon le plan A-A de la vue 1b, et une vue en coupe (1b) selon le plan B-B de la vue 1a, illustrant le résultat d'une étape d'un mode de réalisation d'un procédé de fabrication d'une mémoire à changement de phase ;

la figure 2 comprend une vue en coupe (2a) selon le plan A-A de la vue 2b, et une vue en coupe (2b) selon le plan B-B de la vue 2a, illustrant le résultat d'une autre étape d'un mode de réalisation d'un procédé de fabrication d'une mémoire à changement de phase ;

la figure 3 comprend une vue en coupe (3a) selon le plan A-A de la vue 3b, et une vue en coupe (3b) selon le plan B-B de la vue 3a, illustrant le résultat d'une autre étape d'un mode de réalisation d'un procédé de fabrication d'une mémoire à changement de phase ;

la figure 4 comprend une vue en coupe (4a) selon le plan A-A de la vue 4b, et une vue en coupe (4b) selon le plan B-B de la vue 4a, illustrant le résultat d'une autre étape d'un mode de réalisation d'un procédé de fabrication d'une mémoire à changement de phase ; et

la figure 5 comprend une vue en coupe (5a) selon le plan A-A de la vue 5b, et une vue en coupe (5b) selon le plan B-B de la vue 5a, illustrant le résultat d'une autre étape d'un mode de réalisation d'un procédé de fabrication d'une mémoire à changement de phase.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les autres composants électroniques contenus dans la mémoire ne sont pas détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Divers exemples de mise en oeuvre et de réalisation sont exposés par la suite. Indépendamment de la dénomination donnée à ces exemples (modes de réalisation, exemples, variantes, etc.) et des qualificatifs employés (par exemple, de préférence, etc.), seules les parties de description incluent dans la portée des revendications font partie de la présente invention, les autres exemples n'étant exposés qu'à titre illustratif et n'étant utiles que pour mettre en évidence des aspects spécifiques à l'invention par rapport à ce qui n'en fait par partie.

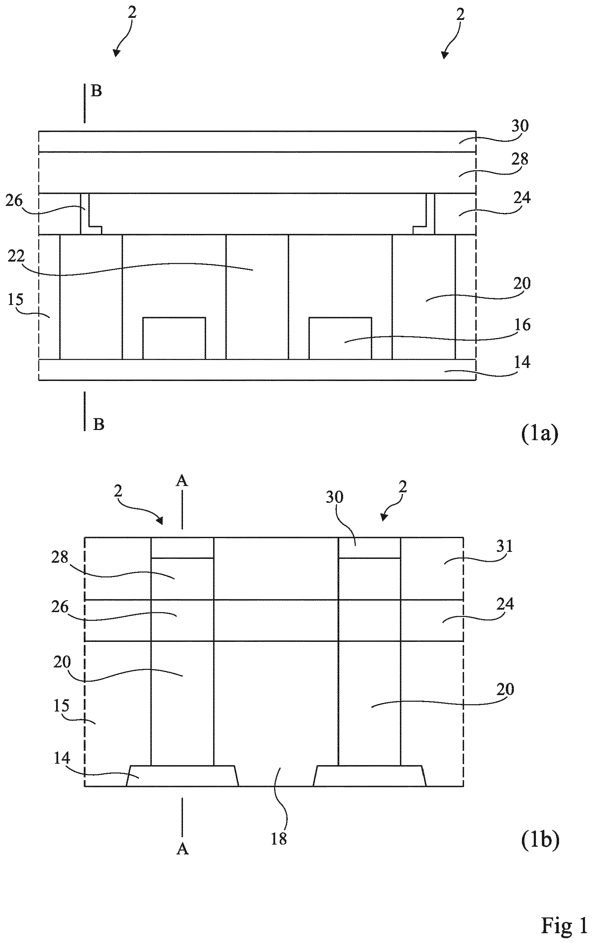

Les figures 1 à 5 représentent les résultats d'étapes successives d'un mode de réalisation d'un procédé de fabrication d'une mémoire à changement de phase.

La figure 1 comprend une vue en coupe (1a) selon le plan A-A de la vue (1b), et une vue en coupe (1b) selon le plan B-B de la vue (1a), illustrant le résultat d'une étape d'un mode de réalisation d'un procédé de fabrication d'une mémoire à changement de phase. Plus précisément, la vue (1a) est une vue en coupe dans la direction d'une ligne de bit et la vue (1b) est une vue en coupe dans la direction d'une ligne de mot. Les vues (1a) et (1b) représentent chacune deux cellules mémoire 2.

La mémoire comprend une couche 14. La couche 14 est par exemple en un matériau semiconducteur, par exemple en silicium. La couche 14 est par exemple une partie d'un substrat massif. La couche 14 peut aussi être une couche de silicium recouvrant une couche isolante dans une structure dite SOI (Silicon on Insulator).

La couche 14 est recouverte d'une couche isolante 15. Des transistors de sélection 16 sont formés dans et sur la couche 14. Les transistors de sélection 16 sont représentés en vue (1a) uniquement par leurs grilles situées dans la couche 15. Les transistors 16 de différentes lignes de bit sont séparés les uns des autres par des tranchées isolantes 18 (vue (1b)) s'étendant à travers la couche 14.

Des contacts (ou vias) 20 et 22 traversent la couche isolante 15 de manière à prendre contact avec les zones de source et de drain des transistors de sélection 16.

La couche 15 est recouverte d'une couche 24 isolante pouvant comprendre plusieurs types d'isolants. Des éléments résistifs 26 s'étendent, dans la couche 24, entre les contacts 20 et des bandes 28 de matériau à changement de phase. Chaque bande 28 est recouverte d'une bande 30 de matériau conducteur, dont les dimensions horizontales sont sensiblement égales aux dimensions horizontales de la bande 28. Les éléments résistifs 26, la bande 28 et la bande 30 d'une même ligne de bit sont par exemple gravés ensemble.

Les éléments résistifs ont, dans cet exemple, un profil en forme de L. Plus précisément, dans le mode de réalisation des vues (1a) et (1b), les éléments résistifs 26 ont une section, dans le plan de coupe de la vue (1a), en forme de L.

Chaque ligne de bit comprend une bande 28 qui est commune à toute la ligne de bit et qui est en contact avec les éléments résistifs 26 de toute la ligne de bit. De même, chaque ligne de bit comprend une bande 30 de matériau conducteur recouvrant la bande 28. Les bandes 28 et 30 des différentes lignes de bit sont isolées latéralement les unes des autres par des régions d'isolant 31.

Les contacts 22 sont par exemple en contact avec une zone de source ou de drain commune à deux transistors 16 voisins d'une même ligne de bit. Les contacts 22 d'une même ligne de mot sont interconnectés, par exemple par une barre conductrice non représentée.

Ainsi, pour mémoriser une valeur dans une cellule mémoire, une tension est appliquée entre la couche 30 de la ligne de bit associée à la cellule mémoire et le contact 20 de la ligne de mot, tout en rendant passant le transistor 16 de sélection situé entre le contact 22 de la cellule mémoire et le contact 20 de la ligne de mot.

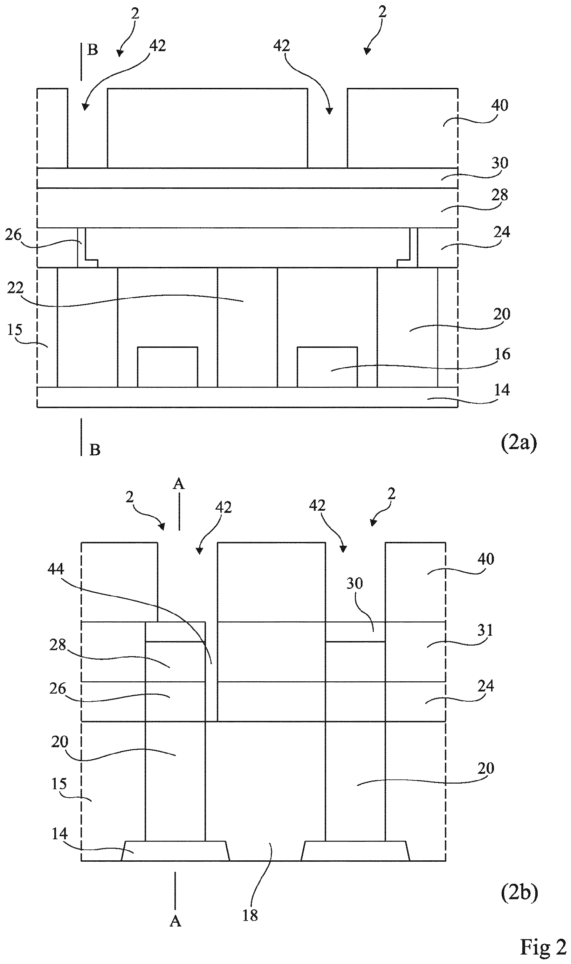

La figure 2 comprend une vue en coupe (2a) selon le plan A-A de la vue (2b), et une vue en coupe (2b) selon le plan B-B de la vue (2a), illustrant le résultat d'une autre étape d'un mode de réalisation d'un procédé de fabrication d'une mémoire à changement de phase.

Au cours de cette étape, une couche 40 est formée sur la face supérieure de la couche isolante 31 et sur la face supérieure des bandes 30 de matériau conducteur. La couche 40 est une couche isolante, par exemple en oxyde de silicium ou en nitrure de silicium.

Des cavités 42 sont formées dans la couche isolante 40. Les cavités 42 sont donc formées après la formation des bandes 28 de matériau à changement de phase. Les cavités sont par exemple des cavités cylindriques. Les cavités permettront la formation de contacts conducteurs avec les lignes de bits, par exemple la formation de vias conducteurs. Les cavités s'étendent de la face supérieure de la couche 40 et jusqu'au niveau de la face supérieure des bandes 30. Chaque ligne de bit comprendra plusieurs contacts. Chacune des vues de la figure 2 représente deux cavités 42 qui permettront chacune la formation d'un via conducteur. Les deux bornes de la cellule mémoire à changement de phase seront donc les contacts 20 et les contacts qui seront formés dans les cavités 42.

Les cavités 42 sont situées à l'aplomb des bandes 30. De préférence, les cavités 42 sont situées en regard des bandes 30 et non en regard de la couche isolante 31. Cependant, les cavités peuvent être décalées, par exemple lorsqu'un masque de gravure n'est pas correctement aligné ou n'est pas correctement formé.

La gravure est de préférence une gravure sélective du matériau de la couche isolante 40 par rapport au matériau des bandes 30. Par exemple, la gravure grave au moins cinq fois plus vite le matériau de la couche 40 que le matériau des bandes 31.

La durée de la gravure des cavités 42 est choisie de manière à s'assurer que toutes les cavités atteignent les bandes 30, c'est-à-dire pour s'assurer que les bandes 30 forment les fonds des cavités 42.

Lorsque les cavités sont décalées, la gravure risque ainsi de durer suffisamment longtemps pour atteindre la couche 31, et éventuellement la couche 24.

Dans l'exemple de la figure 2, la cavité 42 de gauche de la vue (2b) est décalée par rapport à la bande 30 et une cavité secondaire 44 est ainsi formée dans les couches 31 et 24. La cavité 42 comprend donc la cavité secondaire 44.

De manière plus générale, il peut y avoir plusieurs cavités 42 décalées et donc plusieurs cavités secondaires 44. Par exemple, toutes les cavités peuvent être décalées, par exemple à cause d'un décalage du masque de gravure.

La bande 30 et des éléments résistifs 28 sont ainsi découvertes lors de la gravure. Au moins une partie des parois de la cavité secondaire 44 est constituée des parois latérales des bandes 30 et 28, et des parois latérales des éléments résistifs 26.

On pourrait former les contacts en remplissant directement les cavités d'un matériau conducteur. Cependant, les cavités secondaires 44 seraient alors aussi remplies de matériau conducteur. Il pourrait alors y avoir une connexion électrique directe entre la bande 30 et un des éléments résistifs, c'est-à-dire une connexion par l'intermédiaire du matériau conducteur et non par l'intermédiaire de la bande 28 de matériau à changement de phase. Une telle connexion perturberait la mémorisation d'une donnée dans la cellule mémoire correspondante. Dans le cas où la cavité secondaire 44 n'atteint pas d'élément résistif 26, elle pourrait cependant atteindre la bande 28 de matériau à changement de phase. Cette connexion pourrait alors chauffer le matériau à changement de phase lors d'une étape de mémorisation d'une donnée, ce qui pourrait modifier l'état de la bande 28 et en particulier sa résistance au niveau des cellules mémoire. Cette différence de résistance pourrait entraîner des perturbations dans la lecture de la donnée mémorisée.

De plus, il pourrait être impossible de déterminer la présence de cavités 44 dans la mémoire avant la formation des contacts.

Dans l'exemple de la figure 2, les cavités, et donc les contacts, ont des dimensions horizontales (en vue 2b) sensiblement égale à celles de la bande 30. On pourrait choisir de faire des contacts, par exemple des vias conducteurs, plus petits pour avoir une marge de manoeuvre plus grande en cas de désalignement. Cependant, la diminution des dimensions des contacts peut ne pas être possible ou peut entraîner des difficultés de fabrication, par exemple une augmentation des coûts de fabrication.

A titre de variante, les cavités 42 peuvent avoir la forme de tranchées, de manière à permettre la formation de barres conductrices. Ces barres conductrices permettraient par exemple de connecter ensemble toutes les cellules mémoire d'une ligne de mot ou d'une ligne de bit. Les étapes décrites par la suite sont identiques dans le cas de cavité ayant des formes de tranchées, ou d'autres formes.

A titre de variante, les cavités peuvent avoir des formes différentes. Par exemple, au moins certaines des cavités 42 peuvent avoir une forme permettant la formation de vias conducteurs. De plus, au moins certaines cavités 42 peuvent avoir des formes permettant la formation de barres conductrices. Au moins certaines autres cavités peuvent avoir d'autres formes.

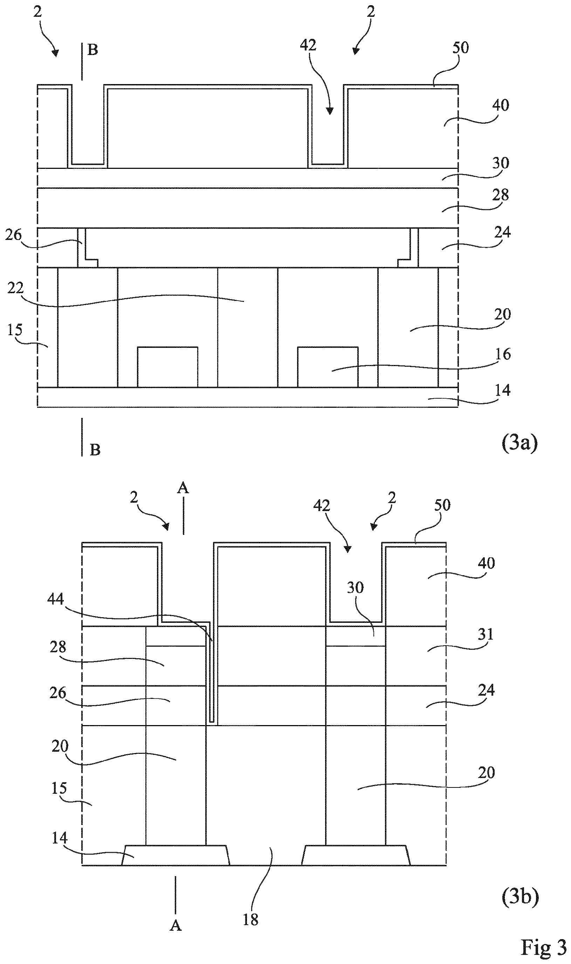

La figure 3 comprend une vue en coupe (3a) selon le plan A-A de la vue (3b), et une vue en coupe (3b) selon le plan B-B de la vue (3a), illustrant le résultat d'une autre étape d'un mode de réalisation d'un procédé de fabrication d'une mémoire à changement de phase.

Au cours de cette étape, une couche isolante 50 est formée sur la structure décrite en relation avec la figure 2. La couche 50 est par exemple déposée ou formée de manière conforme sur la structure, c'est-à-dire qu'elle recouvre toutes les surfaces accessibles à partir de la face supérieure de la structure. En particulier, la couche 50 s'étend sur la face supérieure de la couche 40, sur les parois et sur le fond des cavités 42 et sur les parois et le fond des cavités secondaires 44. La couche 50 s'étend donc sur les parties découvertes des bandes 30 et 28 et sur les parties découvertes des éléments résistifs 26.

La couche 50 peut éventuellement remplir entièrement la cavité secondaire 44.

La couche 50 a par exemple une épaisseur comprise entre environ 2 nm et environ 5 nm. La cavité secondaire 44 peut alors remplir entièrement des cavités dont la dimension horizontale, dans le plan de la vue (3b) est comprise entre environ 4 nm et environ 10 nm.

L'épaisseur de la couche 50 est supérieure à l'épaisseur des bandes 30.

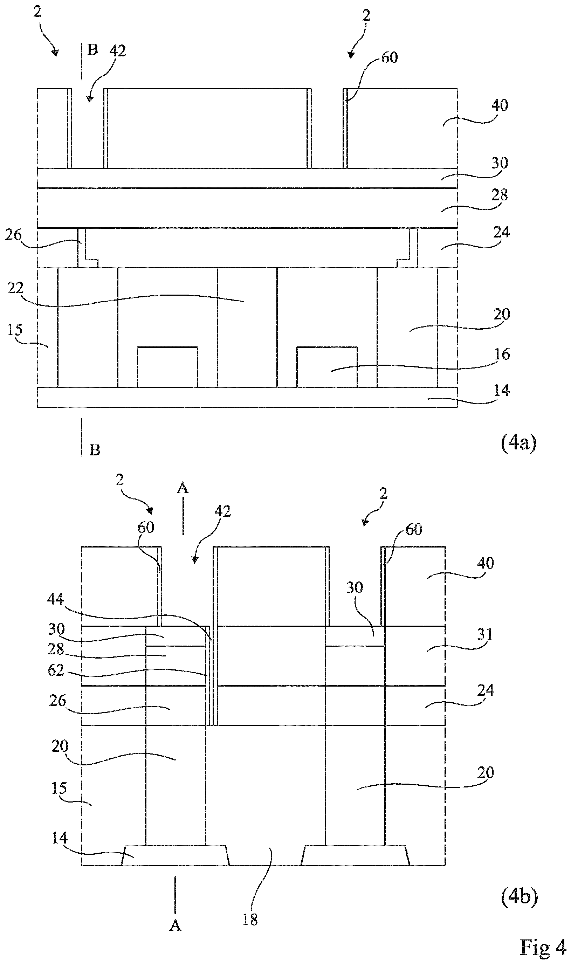

La figure 4 comprend une vue en coupe (4a) selon le plan A-A de la vue (4b), et une vue en coupe (4b) selon le plan B-B de la vue (4a), illustrant le résultat d'une autre étape d'un mode de réalisation d'un procédé de fabrication d'une mémoire à changement de phase.

Au cours de cette étape, une gravure est effectuée. Cette gravure est par exemple une gravure sélective du matériau de la couche 50 par rapport au matériau de la bande 30.

Par exemple, le procédé grave le matériau de la couche 50 au moins cinq fois plus vite qu'il ne grave le matériau de la couche 30.

La gravure est une gravure anisotrope, c'est-à-dire une gravure qui grave dans la direction verticale. Ainsi, les portions horizontales de la couche 50 situées au fond des cavités 42 et 44 sont gravées. De plus, les portions horizontales de la couche 50 situées sur la face supérieure de la couche 30 sont gravées. La couche 50 est donc, après gravure, présente sur les parois latérales des cavités 42 et 44.

Les parties des bandes 30 formant le fond des cavités sont ainsi découvertes. Il sera ainsi possible de former une connexion électrique avec la face supérieure des bandes 30.

Les portions verticales de la couche 50, c'est-à-dire les portions 60 situées sur les parois des cavités 42 et les portions 62 situées sur les parois des cavités 44, ne sont pas gravées. En particulier les portions 62 situées sur les parois latérales des bandes 30 et 28 et sur les parois latérales des éléments résistifs ne sont pas gravées. Ainsi, les parois latérales des bandes 30 et 28 et les parois latérales des éléments résistifs 26 ne sont pas découvertes.

Éventuellement, la gravure peut retirer une partie supérieure des portions horizontales 62 recouvrant les parois latérales des cavités 44. Par exemple, une partie des parois latérales de la bande 30 peut être découverte. L'épaisseur de la couche 50 est supérieure à l'épaisseur des bandes 30. Ainsi, lorsque la gravure retire une épaisseur de matériau de la couche 50 égale sensiblement à l'épaisseur de la couche 30, les portions 62 ne peuvent être gravées sur toute la hauteur de la bande 30. La gravure ne risque donc pas de découvrir une partie des parois latérales de la bande 28 et/ou des éléments conducteurs 26.

De la même manière, si la cavité 44 est entièrement remplie par la couche isolante 50, la gravure peut retirer une partie supérieure de la couche isolante 50 située dans la cavité 44, mais pas suffisamment pour atteindre la bande 28.

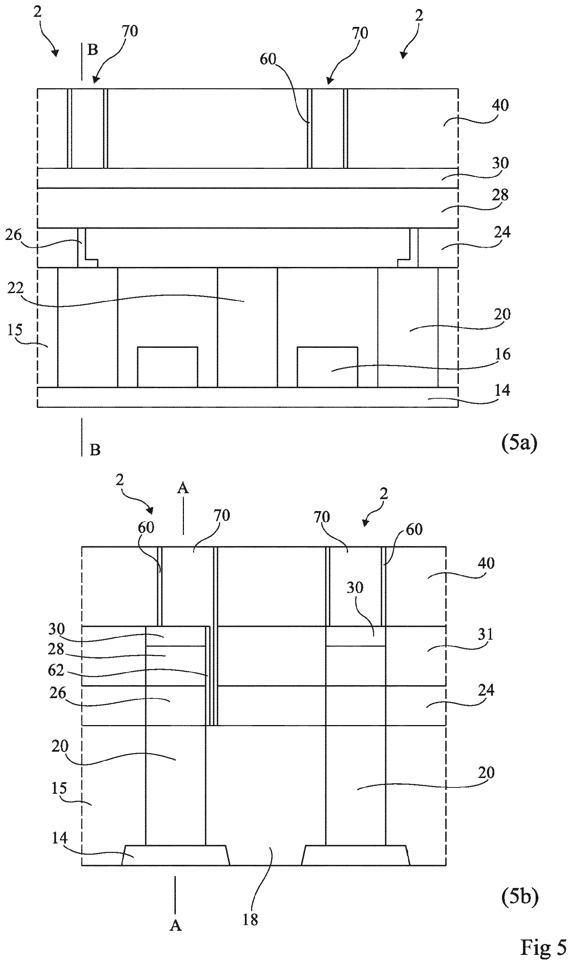

La figure 5 comprend une vue en coupe (5a) selon le plan A-A de la vue (5b), et une vue en coupe (5b) selon le plan B-B de la vue (5a), illustrant le résultat d'une autre étape d'un mode de réalisation d'un procédé de fabrication d'une mémoire à changement de phase.

Au cours de cette étape, les cavités 42, et éventuellement les cavités 44 si elles ne sont pas remplies par la couche isolante 50, sont remplies d'un matériau conducteur, par exemple du cuivre, de manière à former des contacts 70. Les contacts 70 sont, dans l'exemple représentés, des vias conducteurs, mais pourraient aussi être des barres conductrices ou d'autres éléments conducteurs. Il y a donc une connexion électrique entre les contacts 70 et les bandes 30. Il n'y a cependant pas de contact électrique entre les contacts 70 et les bandes 28 et les éléments résistifs 26.

À titre de variante, les contacts 70 peuvent avoir des dimensions horizontales supérieures aux dimensions horizontales de la bande 30. Ainsi il est possible que des cavités 44 soient créées des deux côtés des bandes 28 et 30. Les étapes de procédé décrites précédemment s'appliquent de la même manière.

Un avantage des modes de réalisation décrits précédemment est qu'ils permettent d'obtenir des mémoires à changement de phase comprenant des contacts ne formant pas de court-circuit et n'étant pas en connexion électrique directe avec le matériau à changement de phase 28 ou les éléments résistifs 26.

Un autre avantage des modes de réalisation décrits est qu'ils permettent d'obtenir des contacts 70 sans court-circuit même lorsque les contacts sont décalés.

Un autre avantage des modes de réalisation décrits est qu'ils permettent d'avoir moins de restrictions sur la dimension des contacts 70. En effet les modes de réalisation décrits peuvent comprendre des contacts 70 de dimensions horizontales plus élevées que les dimensions des bandes 28 de matériaux à changement de phase.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art.

Enfin, la mise en oeuvre pratique des modes de réalisation et variantes décrits est à la portée de l'homme du métier à partir des indications fonctionnelles données ci-dessus.

## Revendications

1. Procédé de fabrication d'une mémoire à changement de phase comprenant :
- la formation d'une première couche isolante (50) dans des cavités (42) situées à l'aplomb de bandes de matériau à changement de phase (28) ; et
- la gravure anisotrope des parties de la première couche isolante (50) situées au fond des cavités (42) dans lequel chaque bande de matériau à changement de phase (28) est recouverte d'une bande conductrice (30),
**caractérisé en ce que** l'épaisseur de la première couche isolante (50) est supérieure à l'épaisseur des bandes conductrices (30).

2. Dispositif mémoire à changement de phase comprenant une première couche isolante (50, 60, 62) contre des parois latérales de cavités (42) situées à l'aplomb de bandes de matériau à changement de phase (28), dans lequel chaque bande de matériau à changement de phase (28) est recouverte d'une bande conductrice (30),
**caractérisé en ce que** l'épaisseur de la première couche isolante (50, 60, 62) est supérieure à l'épaisseur des bandes conductrices (30).

3. Procédé selon la revendication 1 ou dispositif mémoire selon la revendication 2, dans lequel les cavités (42) sont formées dans une deuxième couche isolante (40) et atteignent la face supérieure de bandes conductrices (30).

4. Procédé selon la revendication 3, comprenant les étapes suivantes :
- former des transistors de sélection (16) dans et sur une couche (14) de silicium ;
- former des premiers vias (20) et des deuxièmes vias (22) de reprise de contact avec les transistors, à travers une troisième couche isolante (15) ;
- former des éléments résistifs (26) à l'aplomb desdits premiers vias (20) ;
- former les bandes de matériau à changement de phase (28) ;
- former les bandes conductrices (30) sur les bandes de matériau à changement de phase (28) ;
- former la deuxième couche isolante (40) ; et
- former lesdites cavités (42) dans la deuxième couche isolante.

5. Procédé selon l'une quelconque des revendication 1, 3 à 4, ou dispositif mémoire selon la revendication 2 ou 3, dans lequel au moins une cavité (42) comprend une cavité secondaire (44), au moins une partie d'une des parois de la cavité secondaire (44) étant en matériau à changement de phase.

6. Procédé ou dispositif mémoire selon la revendication 5, dans lequel une partie d'une des parois d'au moins une cavité secondaire (44) est constituée par un élément résistif (26).

7. Procédé ou dispositif mémoire selon la revendication 5 ou 6, dans lequel au moins une cavité secondaire (44) est remplie par la première couche isolante (62).

8. Procédé selon l'une quelconque des revendication 1, 3 à 7, ou dispositif mémoire selon l'une quelconque des revendications 2, 3, 5, 6, 7, dans lequel les cavités (42) sont remplies de matériau conducteur de manière à former des contacts (70).

9. Procédé ou dispositif mémoire selon la revendication 9, dans lequel au moins certains des contacts (70) sont des vias conducteurs.

10. Procédé ou dispositif mémoire selon la revendication 9, dans lequel au moins certains des contacts (70) sont des barres conductrices.

11. Procédé selon l'une quelconque des revendications 1, 3 à 10, ou dispositif mémoire selon l'une quelconque des revendications 2, 3, 5 à 10, dans lequel l'épaisseur de la première couche isolante (50, 60, 62) est comprise entre 2 nm et 5 nm.

## Patentansprüche

1. Verfahren zur Herstellung eines Phasenwechselspeichers, wobei das Verfahren Folgendes aufweist:
- Ausbilden einer ersten Isolierschicht (50) in Hohlräumen (42), die vertikal in einer Linie mit Streifen aus Phasenwechselmaterial (28) angeordnet sind; und
- anisotropes Ätzen von Teilen der ersten Isolierschicht (50), die sich am Boden der Hohlräume (42) befinden
wobei jeder Streifen aus Phasenwechselmaterial (28) mit einem leitenden Streifen (30) bedeckt ist,
**dadurch gekennzeichnet, dass** die Dicke der ersten Isolierschicht (50) größer ist als die Dicke der leitenden Streifen (30).

2. Phasenwechselspeichervorrichtung aufweisend eine erste Isolierschicht (50, 60, 62) anliegend an Seitenwänden von Hohlräumen (42), die vertikal in einer Linie mit Streifen aus Phasenwechselmaterial (28) angeordnet sind, wobei jeder Streifen aus Phasenwechselmaterial (28) mit einem leitenden Streifen (30) bedeckt ist,
**dadurch gekennzeichnet, daß** die Dicke der ersten Isolierschicht (50, 60, 62) größer ist als die Dicke der leitenden Streifen (30).

3. Verfahren nach Anspruch 1 oder Speichervorrichtung nach Anspruch 2, wobei die Hohlräume (42) in einer zweiten Isolierschicht (40) ausgebildet sind und die Oberseite der leitenden Streifen (30) erreichen.

4. Verfahren nach Anspruch 3, das die folgenden Schritte aufweist:
- Ausbilden von Auswahltransistoren (16) innerhalb und auf einer Siliziumschicht (14);
- Ausbilden von ersten Durchkontaktierungen (20) und zweiten Durchkontaktierungen (22) zur Kontaktierung der Transistoren durch eine dritte Isolierschicht (15);
- Ausbilden von Widerstandselementen (26) vertikal in einer Linie mit den ersten Durchkontaktierungen (20);
- Ausbilden der Streifen aus Phasenwechselmaterial (28);
- Ausbilden der leitenden Streifen (30) auf den Streifen aus Phasenwechselmaterial (28);
- Ausbilden der zweiten Isolierschicht (40); und
- Ausbilden der Hohlräume (42) in der zweiten Isolierschicht.

5. Verfahren nach einem der Ansprüche 1, 3 bis 4 oder Speichervorrichtung nach einem der Ansprüche 2 oder 3, wobei mindestens ein Hohlraum (42) einen sekundären Hohlraum (44) aufweist, wobei mindestens ein Teil einer der Wände des sekundären Hohlraums (44) aus einem Phasenwechselmaterial hergestellt ist.

6. Verfahren oder Speichervorrichtung nach Anspruch 5, wobei ein Teil einer der Wände mindestens eines sekundären Hohlraums (44) durch ein Widerstandselement (26) gebildet wird.

7. Verfahren oder Speichervorrichtung nach Anspruch 5 oder 6, wobei mindestens ein sekundärer Hohlraum (44) durch die erste Isolierschicht (62) gefüllt ist.

8. Verfahren nach einem der Ansprüche 1, 3 bis 7 oder Speichervorrichtung nach einem der Ansprüche 2, 3, 5, 6, 7, wobei die Hohlräume (42) mit leitenden Materialien gefüllt sind, um Kontakte (70) zu bilden.

9. Verfahren oder Speichervorrichtung nach Anspruch 9, wobei mindestens einige der Kontakte (70) leitende Durchkontaktierungen sind.

10. Verfahren oder Speichervorrichtung nach Anspruch 9, wobei mindestens einige der Kontakte (70) leitende Stäbe sind.

11. Das Verfahren nach einem der Ansprüche 1, 3 bis 10 oder die Speichervorrichtung nach einem der Ansprüche 2, 3, 5 bis 10, wobei die Dicke der ersten Isolierschicht (50, 60, 62) im Bereich von 2 nm bis 5 nm liegt.

## Claims

1. A method of manufacturing a phase-change memory, comprising:
- forming a first insulating layer (50) in cavities (42) located vertically in line with strips of phase-change material (28); and
- anisotropically etching portions of the first insulating layer (50) located at the bottom of the cavities (42)
wherein each strip of phase-change material (28) is covered with a conductive strip (30),
**Characterized in that** the thickness of the first insulating layer (50) is greater than the thickness of the conductive strips (30).

2. A phase-change memory device comprising a first insulating layer (50, 60, 62) against lateral walls of cavities (42) located vertically in line with strips of phase-change material (28), wherein each strip of phase-change material (28) is covered with a conductive strip (30),
**Characterized in that** the thickness of the first insulating layer (50, 60, 62) is greater than the thickness of the conductive strips (30).

3. The method of claim 1 or the memory device of claim 2, wherein the cavities (42) are formed in a second insulating layer (40) and reach the upper surface of conductive strips (30) .

4. The method of claim 3, comprising the steps of:
- forming selection transistors (16) inside and on top of a silicon layer (14);
- forming first vias (20) and second vias (22) for contacting the transistors, through a third insulating layer (15);
- forming resistive elements (26) vertically in line with said first vias (20);
- forming the strips of phase-change material (28);
- forming the conductive strips (30) on the strips of phase-change material (28);
- forming the second insulating layer (40); and
- forming said cavities (42) in the second insulating layer.

5. The method of any of claims 1, 3 to 4, or the memory device of any of claims 2 or 3, wherein at least one cavity (42) comprises a secondary cavity (44), at least a portion of one of the walls of the secondary cavity (44) being made of a phase-change material.

6. The method or memory device of claim 5, wherein a portion of one of the walls of at least one secondary cavity (44) is formed by a resistive element (26).

7. The method or memory device of claim 5 or 6, wherein at least one secondary cavity (44) is filled by the first insulating layer (62).

8. The method of any of claims 1, 3 to 7, or the memory device of any of claims 2, 3, 5, 6, 7, wherein the cavities (42) are filled with conductive materials to form contacts (70).

9. The method or memory device of claim 9, wherein at least some of the contacts (70) are conductive vias.

10. The method or memory device of claim 9, wherein at least some of the contacts (70) are conductive bars.

11. The method of any of claims 1, 3 to 10 or the memory device of any of claims 2, 3, 5 to 10, wherein the thickness of the first insulating layer (50, 60, 62) is in the range from 2 nm to 5 nm.
